# EUROPÄISCHE PATENTSCHRIFT

(11) **EP 0 334 109 B1**
(45) Veröffentlichungstag und Bekanntmachung des Hinweises auf die Patenterteilung: **02.06.1993**
(21) Anmeldenummer: 89104129.5
(22) Anmeldetag: 08.03.1989
(51) Int. Cl.: C23C 16/50, H01J 37/32, C23C 16/22

(54) **Verfahren und Vorrichtung zum Herstellen von aus amorphen Silizium-Germanium-Legierungen bestehenden Halbleiterschichten nach der Glimmentladungstechnik, insbesondere für Solarzellen**
Process and apparatus for the production of semiconducting layers made of silicium-germanium alloys by flow discharge technics and particularly of solar cells
Procédé et appareillage de fabrication par décharge luminescente de couches semi-conductrices composées d'alliages silicium-germanium, et en particulier de cellules solaires

(30) Priorität: 24.03.1988 DE 3810021
(43) Veröffentlichungstag der Anmeldung: 27.09.1989
(73) Patentinhaber: SIEMENS AKTIENGESELLSCHAFT, 80333 München (DE)
(72) Erfinder: Kausche, Helmold, Dipl.-Phys., D-8000 München 71 (DE); Plättner, Rolf, Dr., D-8012 Riemerling (DE)

(56) Entgegenhaltungen:
- EP-A- 0 224 360
- EP-A- 0 278 480
- US-A- 4 401 054
- US-A- 4 760 008
- JOURNAL OF NON/3CRYSTALLINE SOLIDS, Band 97, 98, Teil I, Dezember 1987, Elsevier Science Publishers BV, Amsterdam, NL; T.V.HERAK et al.: "Effects of substrate bias on structure and properties of a-Si:H films deposited by ECR microware plasmas", Seiten 227-280
- JOURNAL OF VACUUM SCIENCE & TECHNOLOGY A, Band 4, Nr. 6, November-Dezember 1986, "Second Series", Woodbury, US; J.KOLDZEY et al.: "Properties of a-Si,Ge:H,F alloys prepared by rf glow discharge in an ultrahigh vacuum reactor", Seiten 2499-2504
- JOURNAL OF APPLIED PHYSICS, Band 54, Nr. 11, November 1983, American Institute of Physics, New York, NY, US; S. SUZUKI et al.: "Epitaxial growth od Si-Ge layers on Si substrates by plasma dissociation of SIH4 and GeH4 mixture", Seiten 6385-6389

## Beschreibung

Die Erfindung betrifft ein Verfahren zum Herstellen von dünnen Schichten, insbesondere aus Halbleitermaterial, durch Abscheidung aus der Gasphase, wobei gasförmige das abzuscheidende Material enthaltende Verbindungen als Prozeßgas in einem Reaktor zwischen Elektroden in einem Gasentladungsplasma (Niederdruckplasma) angeregt und als feste Schichten auf den Elektroden bzw. den dort angebrachten Substraten niedergeschlagen werden, sowie Vorrichtungen zur Durchführung des Verfahrens.

Verfahren und Vorrichtungen dieser Art für die Abscheidung reiner amorpher Siliziumschichten (a-Si:H) sind beispielsweise aus der US-PS 4.292.343 bekannt. Dabei wird in Figur 1 eine kapazititve und in Figur 2 eine induktive HF-Glimmentladungs-Reaktoranordnung beschrieben. Mit Hilfe dieser Verfahren und Vorrichtungen werden pin-Solarzellen auf der Basis von amorphen Silizium auf Substraten hergestellt.

Die Glimmentladungstechnik bietet auch die Möglichkeit, mehrere pin-Zellen verschiedener Bandlücken aufeinander abzuscheiden. Mit solchen Zweifach- oder Dreifach-Tandemzellen kann das gesamte Sonnenspektrum effektiver genutzt werden, was zu einem höheren Zellwirkungsgrad führt. Die Bandlücke kann durch Zusatz von Germanium zum amorphen Silizium erniedrigt werden, wodurch die Zelle rotempfindlicher wird.

Die Zustandsdichte der Silizium-Germanium-Schichten nimmt mit zunehmendem Germaniumgehalt derart stark zu, daß germaniumreiche Schichten, wie sie für Dünnschicht-Tandem-Solarzellen gebraucht werden (Bandabstand kleiner 1,5 eV), schlechte Halbleitereigenschaften aufweisen. Nach allgemeiner Ansicht liegt das daran, daß die Ionisierungs- und Bindungsenergie eines Wasserstoffatoms bei German (GeH₄) mit 10,5 eV kleiner ist als bei Silan (SiH₄) mit 11,4 eV, so daß im SiGe:H-Material dangling-bonds nicht in dem Maße mit Wasserstoff abgesättigt werden, wie im amorphen Si:H-Material. Ist Silizium und Germanium im amorphen Gefüge nebeneinander vorhanden, so wird bevorzugt Silizium durch Wasserstoff abgesättigt. Es ist deshalb problematisch, bei gleichzeitiger Abscheidung von Silizium und Germanium mit derselben Hochfrequenz, Gleichstromquelle bzw. Lichtquelle Silizium- und Germanium-Atome in der Schicht gleichermaßen mit Wasserstoff abzusättigen.

Eine Verbesserung der dangling-bond-Absättigung in Silizium-Germanium-Legierungen erhält man beispielsweise durch Verdünnen von Silan-German-Mischungen mit Wasserstoff. Die Qualität der Schichten ist jedoch für die Anwendung in Dünnschicht-Tandem-Solarzellen nicht zufriedenstellend.

Aus der EP-A 0 224 360 ist ein Plasmaabscheideverfahren bekannt, bei dem eine Mikrowellen angeregte Electron Cyclotron Resonanz mit einem CVD-Verfahren kombiniert wird.

Aus der US-PS 4 401 054 ist eine Plasmaabscheidevorrichtung bekannt, die eine Mikrowellen angeregte Electron Cyclotron Resonanz verwendet.

Der Erfindung liegt die Aufgabe zugrunde, ein Verfahren und eine Vorrichtung anzugeben, mit denen es möglich ist, dünne Schichten, insbesondere amorphe Silizium-Germanium-Legierungs-schichten herzustellen, die eine ausreichende Absättigung der dangling-bonds mit Wasserstoff oder Fluor gewährleisten und so ihre Verwendung in Dünnschichtsolarzellen mit erhöhtem Wirkungsgrad ermöglichen.

Diese Aufgabe wird erfindungsgemäß gelöst durch ein Verfahren mit den Merkmalen von Patentanspruch 1 und eine Vorrichtung nach Anspruch 18.

Die Erfindung macht sich dabei die aus dem Bericht von E. P. Szuszczewicz aus The Physics of Fluids, Vol. 15, Nr. 12, Dezember 1972, Seiten 2240 bis 2246, gewonnene Erkenntnis zunutze, daß bei Überlagerung eines induktiv angeregten Plasmas mit einem schwachen Magnetfeld Wellenresonanz, das heißt Helikonresonanz auftritt. In diesem speziellen Fall wird eine Elektron-Zyklotron-Wellenresonanz durch Überlagerung eines schwachen statischen Magnetfeldes senkrecht zu einem durch induktive HF- Ankopplung erzeugtem Plasma erhalten. Beim Anmeldungsgegenstand kann durch die Überlagerung des magnetischen Gleichfeldes die ins Plasma eingekoppelte HF-Welle in eine links-und eine rechts-zirkulare Welle aufgeteilt werden. Im Resonanzfall wird die linkszirkulare Welle wie beim Skin-Effekt in einem leitfähigen Medium, dem Plasma, gedämpft. Die rechtszirkulare Welle unterliegt im Resonanzfall praktisch keiner Dämpfung, sie dringt ins Plasma ein und erhöht dadurch die Ionisierungsdichte.

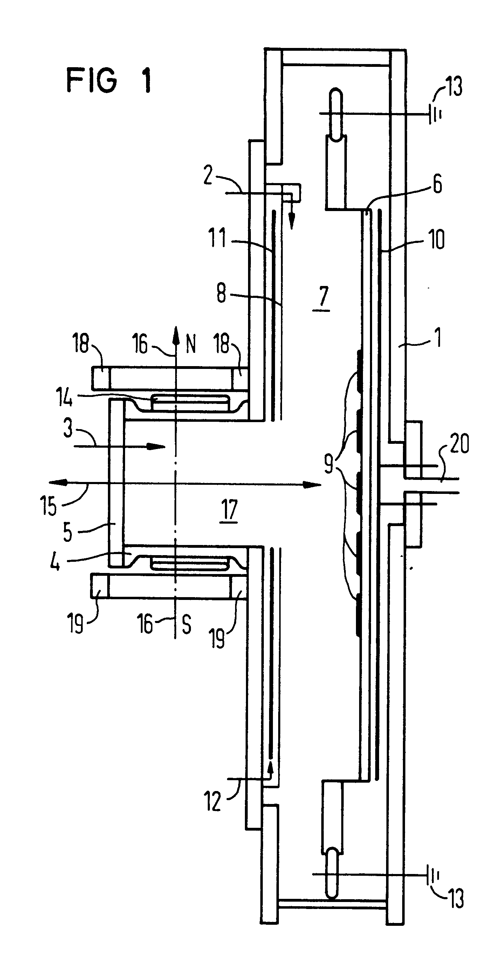

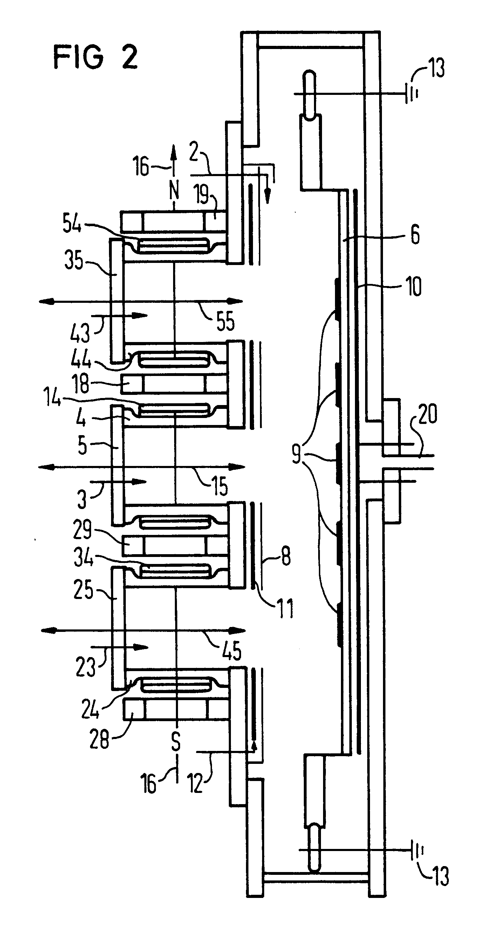

Weitere Ausgestaltungen der Erfindung, insbesondere Vorrichtungen zur Durchführung des Verfahrens, ergeben sich aus den Unteranspruchen sowie nachfolgend anhand der Beschreibung zu den Figuren 1 und 2. Dabei zeigt
- Figur 1: eine Reaktoranordnung mit kapazitiver HF-Anregung und induktiver Anregung mit überlagertem senkrechten magnetischem Gleichfeld (Wellenresonanz bzw. Helikonresonanz) und
- Figur 2: eine Vorrichtung, bei der durch Vervielfachung der induktiven Einkopplung auch große Substratflächen beschichtet werden können.

Figur 1: Die für die Herstellung von amorphen, hydrogenisierten Silizium-Germanium-Schichten vorgesehenen gasförmigen Verbindungen werden, in diesem Ausführungsbeispiel bestehend aus German an der mit dem Pfeil 2 bezeichneten Stelle, aus Wasserstoff beim Pfeil 3 und aus Silan im Zwischenbereich dieser beiden Einlässe an der mit dem Pfeil 12 bezeichneten Stelle in den aus Edelstahl bestehenden Reaktor 1 eingeleitet, nachdem dieser vorher auf einen Restgaspartialdruck von etwa 10⁻⁶ mbar evakuiert worden war. An den Reaktor 1 ist im Mittelteil ein Quarzglasflansch 4 angebracht, der mit einem Metalldeckel 5 verschlossen ist. Dieser Metalldeckel 5 enthält die Zuleitung 3 für den Wasserstoff und dient zugleich zum Anlegen einer Gleichspannung von ± 200 V, vorzugsweise von 60 V zwischen dem Plasma und der Substrathalteplatte 6 zur positiven oder negativen Beschleunigung der Ionen aus dem hochangeregten Plasma (17). Durch Einspeisen von HF-Energie (13, 5 MHz) wird die Glimmentladung 7 von German (2) zwischen der Elektrode 8 und den Substraten 9 mit der als Substrathalter 6 dienenden Elektrode in Gang gesetzt. Beide Elektroden 6, 8 werden mittels der Elektrodenheizung 10 und 11 auf 100 bis 300°C aufgeheizt. An den mit 13 bezeichneten Stellen ist die Elektrode 6 geerdet. Mit 20 ist die Gasableitung zur Vakuumpumpe bezeichnet.

Gleichzeitig mit der Plasmaanregung 7 für das German erfolgt auch die Plasmaanregung 17 für den Wasserstoff und das eindiffundierende Silan (12) und German (2). Dafür besitzt die Elektrode 8 im Zentrum einen Durchbruch, in dem der Quarzglasflansch 4 an den Reaktor 1 angebracht ist, durch den das mit dem Wasserstoff (3) gemischte Silan und German an die Substrate 9 gelangt. Beide Reaktionsgase werden durch ein induktiv angeregtes Plasma 17, ausgehend von einer Induktionsspule 14 ionisiert (HF-Energie 27 MHz). Im zentralen Substratbereich 9 mischen sich angeregtes Silan und German und die beiden Plasmen 7, 17 überlagern und beeinflussen sich zum Teil. Zur Erhöhung der Ionisierungsdichte wird dem induktiv angeregten Plasma 17 senkrecht zum HF-Magnetfeld (siehe Doppelpfeil 15) ein magnetisches Gleichfeld 16 (siehe Pfeil NS) überlagert.

Bei richtiger Wahl des magnetischen Gleichfeldes, das heißt beim günstigen Spulenstrom in zwei, außen angebrachte und gleichsinnig gepolte Spulen 18 und 19 tritt dann die oben bereits beschriebene Wellenresonanz, das heißt Helikonresonanz auf. Dabei erfolgt die Anordnung der Magnetspulen 18, 19 in der sogenannten Helmholtz-Anordnung, wobei der Spulenabstand gleich dem Spulenradius ist.

Durch die weitgehend unabhängig voneinander wählbare Einspeisung von Energie über die kapazitiv angeregte HF-Entladung 7 und die induktiv eingekoppelte HF-Entladung 17 nahe der Wellenresonanz zur Anregung von German, Silan und Wasserstoff und die unabhängig einstellbare Beschleunigungsspannung können in Verbindung mit einem angepaßten Gasdruck und -fluß für Silan, German und Wasserstoff günstige Abscheidebedingungen für ein amorphes a-SiGe:H-Material mit geringer Zustandsdichte gefunden werden. Zum Beispiel wird bei einem Druck von 10⁻² mbar der Gesamtfluß auf 50 - 100 sccm bei einem SiH₄:GeH₄-Fluß von 10:1 eingestellt.

Figur 2: Mit der hier abgebildeten Reaktoranordnung, für die im wesentlichen die gleichen Bezugszeichen gelten wie in Figur 1, können homogene Abscheidungen auch auf großen Substratflächen erzielt werden. Mit den Bezugszeichen 4, 24, 44 sind die Quarzglasflansche, mit 5, 25, 35 deren Deckel, mit 3, 23, 43 die Wasserstoffzuleitungen, mit 14, 34, 54 die Induktionsspulen, mit 15, 45, 55 die Richtung der HF-Magnetfelder und mit 18, 19, 28, 29 die entsprechenden Magnetspulen bezeichnet.

Das erfindungsgemäße Verfahren läßt sich nicht nur für die Herstellung amorpher wasserstoffhaltiger Si-Ge-Schichten oder anderer Halbleitermaterialschichten verwenden, sondern ist überall dort anwendbar, wo mit Hilfe der Glimmentladungstechnik dünne Materialschichten erzeugbar sind, zum Beispiel auch für Kunststoffschichten.

## Patentansprüche

1. Verfahren zum Herstellen von dünnen Schichten durch Abscheidung aus der Gasphase, bei dem gasförmige das abzuscheidende Material enthaltende Prozeßgase (2, 3, 12) in einem Gasentladungs-Plasma angeregt werden, wobei das Plasma (17) in einem Reaktorraum erzeugt wird durch eine induktive Hochfrequenzanregung (14), der ein senkrecht zum HF-Feld (15) stehendes konstantes Magnetfeld (16) überlagert ist, so daß eine Elektronencyclotron-Wellenresonanz entsteht, das Prozeßgas hoch ionisiert wird und wobei das Wellenresonanzplasma von einem kapazitiv zwischen zwei Elektroden (6, 8) angeregten HF-Plasma (7) überlagert wird.

2. Verfahren nach Anspruch 1, **dadurch gekennzeichnet,** daß für die induktive Anregung (17) eine Frequenz zwischen 10 und 40 MHz verwendet wird.

3. Verfahren nach Anspruch 2, **dadurch gekennzeichnet,** daß eine Frequenz von 27 MHz verwendet werden.

4. Verfahren nach einem der Ansprüche 1 bis 3, **dadurch gekennzeichnet,** daß für das konstante Magnetfeld (16) eine Feldstärke zwischen 10 und 30 Gauss verwendet wird, um ein Resonanzmaximum der Elektronzyclotron-Wellenresonanz zu erhalten.

5. Verfahren nach einem der Ansprüche 1 bis 4, **dadurch gekennzeichnet,** daß eine Substrat-Trägerplatte (6) in 0 bis 20 cm Abstand zu dem Plasma angeordnet ist.

6. Verfahren nach einem der Ansprüche 1 bis 5, **dadurch gekennzeichnet,** daß ein Prozeßgasdruck zwischen 10⁻³ und 10⁻¹ mbar angewendet wird.

7. Verfahren nach Anspruch 6, **dadurch gekennzeichnet,** daß ein Prozeßgasdruck von 3 x 10⁻² mbar angewendet wird.

8. Verfahren nach einem der Ansprüche 1 bis 7, **dadurch gekennzeichnet,** daß das Prozeßgas Silan (SiH₄) und Wasserstoff (H₂) enthält.

9. Verfahren nach einem der Ansprüche 1 bis 7, **dadurch gekennzeichnet,** daß das Prozeßgas German (GeH₄) und Wasserstoff (H₂) enthält.

10. Verfahren nach einem der Ansprüche 1 bis 9, **dadurch gekennzeichnet,** daß das Prozeßgas aus Wasserstoff- und/oder Fluor-haltigen Silizium- und Germaniumverbindungen besteht.

11. Verfahren nach einem der Ansprüche 1 bis 10, **dadurch gekennzeichnet,** daß das Prozeßgas mit Wasserstoff im Verhältnis 1:5 bis 1:50 verdünnt wird.

12. Verfahren nach einem der Ansprüche 1 bis 11, **dadurch gekennzeichnet,** daß der Wasserstoff (3) durch eine Verschlußplatte (5) auf der den Substraten (9) gegenüberliegenden Seite des Plasmas eingeleitet wird.

13. Verfahren nach einem der Ansprüche 1 bis 12, **dadurch gekennzeichnet,** daß die reaktiven Prozeßgase in den Substratraum eingeleitet werden.

14. Verfahren nach einem der Ansprüche 1 bis 13, **dadurch gekennzeichnet,** daß eine Gleichspannung zwischen 0 und ± 200 Volt zur Beschleunigung oder Abbremsung der Ionen dem Elektronzyklotron-Wellenresonanz-Plasma überlagert wird, angelegt zwischen der Substratträgerplatte (6) und der Verschlußplatte (5), die den Substraten (9) auf der anderen Seite des Plasmas gegenüberliegt.

15. Verfahren nach Anspruch 14, **dadurch gekennzeichnet,** daß die Gleichspannung 60 Volt beträgt.

16. Verfahren nach einem der Ansprüche 1 bis 15, **dadurch gekennzeichnet,** daß außerhalb des Elektronzyklon-Wellenresonanz-Plasmas im Substratraum ein kapazitiv angeregtes Hochfrequenz-Diodenplasma mit 13,5 MHz verwendet wird.

17. Verfahren nach einem der Ansprüche 1 bis 16, **dadurch gekennzeichnet,** daß die Einleitung der Reaktionsgase (2, 12, 3) in den Reaktor (1) so vorgenommen wird, daß Wasserstoff (3) für die induktive Plasmaanregung (17) zentral eingeleitet wird, während für die Wasserstoff- und/oder Fluor-haltige Germaniumverbindung (2) sowie für die Wasserstoff- und/oder Fluor-haltige Siliziumverbindung (12) Einlässe in den Reaktor (1) in den Randbereichen der Substrathalteplatte (6) verwendet werden.

18. Vorrichtung zur Durchführung des Verfahrens nach mindestens einem der Ansprüche 1 bis 17, **gekennzeichnet durch**
a) einen vorwiegend aus Edelstahl bestehenden Reaktor (1) mit mindestens einem im Zentrum in der Reaktorwand angeordneten Flansch (4) aus Glas, der nach außen mit einem Metalldeckel (5) abgedichtet ist,
b) im Reaktor (1) angeordnete, sich gegenüberstehende, beheizbare Elektroden (6, 8, 10,11), die an einen HF-Generator angeschlossen sind, von denen die eine Elektrode (6) geerdet und als Substrathalteplatte ausgebildet ist, während die andere Elektrode (8) im Zentrum des Reaktors (1) im Bereich des Quarzglasflansches (4) mindestens einen Durchbruch aufweist,
c) eine im Metalldeckel (5) enthaltene Gaszuleitung (3),
d) weitere Gaszu- und -ableitungen (2, 12) in der Reaktorwand (1) im Randbereich der mit dem Durchbruch versehenen Elektrode (8),
e) eine HF-Induktionsspule (14), die den Quarzglasflansch (4) umgibt,
f) zwei, außerhalb des Quarzglasflansches (4) angeordnete, gleichsinnig gepolte Magnetspulen (18, 19), sowie
g) Mittel zur Einstellung der Strömungsgeschwindigkeiten und des Druckes der Reaktionsgase im Reaktor (1),
wobei die Induktionsspule (14) und die Magnetspulen (18, 19) so angeordnet sind, daß beim Betrieb der Vorrichtung HF-Feld (15) und konstantes Magnetfeld (16) senkrecht zueinander stehen.

19. Vorrichtung nach Anspruch 18, **dadurch gekennzeichnet,** daß entlang der Seitenwand des Reaktors (1) mehrere Quarzglasflansche (4, 24, 44) und Gaszuleitungen (3, 23, 43) vorgesehen sind, wobei jeweils ein Glaszylinder (4, 24, 44) einem Elektrodendurchbruch gegenüberliegt, und daß jeder Flansch (4, 24, 44) mit einer Induktionsspule (14, 34, 54) und zwei Magnetspulen (18, 19, 28, 29) umgeben ist.

20. Vorrichtung nach Anspruch 18 oder 29, **dadurch gekennzeichnet,** daß der Plasmaraum einen rechteckigen Querschnitt hat und die Substrate (9) senkrecht zur langen Seite des Rechtecks bewegbar sind.

## Claims

1. Method of producing thin layers by deposition from the gas phase, in which gaseous process gases (2, 3, 12) containing the material to be deposited are excited in a gas discharge plasma, the plasma (17) being generated in a reactor chamber by an inductive radio-frequency excitation (14) on which a constant magnetic field (16) which is perpendicular to the RF field (15) is superimposed, with the result that an electroncyclotron wave resonance is produced, the process gas is highly ionised, and an RF plasma (7) capacitively excited between two electrodes (6, 8) being superimposed on the wave resonance plasma.

2. Method according to Claim 1, characterised in that a frequency of between 10 and 40 MHz is used for the inductive excitation (17).

3. Method according to Claim 2, characterised in that a frequency of 27 MHz is used.

4. Method according to one of Claims 1 to 3, characterised in that a field strength of between 10 and 30 gauss is used for the constant magnetic field (16) in order to obtain a resonance maximum in the electroncyclotron wave resonance.

5. Method according to one of Claims 1 to 4, characterised in that a substrate base plate (6) is disposed at a distance of 0 to 20 cm from the plasma.

6. Method according to one of Claims 1 to 5, characterised in that a process gas pressure of between 10⁻³ and 10⁻¹ mbar is used.

7. Method according to Claim 6, characterised in that a process gas pressure of 3 x 10⁻² mbar is used.

8. Method according to one of Claims 1 to 7, characterised in that the process gas contains silane (SiH₄) and hydrogen (H₂).

9. Method according to one of Claims 1 to 7, characterised in that the process gas contains germane (GeH₄) and hydrogen (H₂).

10. Method according to one of Claims 1 to 9, characterised in that the process gas is composed of hydrogen-containing and/or fluorine-containing silicon and germanium compounds.

11. Method according to one of Claims 1 to 10, characterised in that the process gas is diluted with hydrogen in a ratio 1:5 to 1:50.

12. Method according to one of Claims 1 to 11, characterised in that the hydrogen (3) is introduced through a closure plate (5) on the side of the plasma situated opposite the substrates (9).

13. Method according to one of Claims 1 to 12, characterised in that the reactive process gases are introduced into the substrate chamber.

14. Method according to one of Claims 1 to 13, characterised in that a direct voltage of between 0 and ± 200 volts is superimposed on the electroncyclotron wave resonance plasma to accelerate or retard the ions and is applied between the substrate support plate (6) and the closure plate (5) situated opposite the substrates (9) on the other side of the plasma.

15. Method according to Claim 14, characterised in that the direct voltage is 60 volts.

16. Method according to one of Claims 1 to 15, characterised in that a capacitively excited 13.5 MHz radio-frequency diode plasma is used outside the electroncyclotron wave resonance plasma in the substrate chamber.

17. Method according to one of Claims 1 to 16, characterised in that the reaction gases (2, 12, 3) are introduced into the reactor (1) in such a way that hydrogen (3) for the inductive plasma excitation (17) is introduced centrally, whereas inlets in the reactor (1) in the peripheral regions of the substrate holding plate (6) are used for the hydrogen-containing and/or fluorine-containing germanium compound (2) and for the hydrogen-containing and/or fluorine-containing silicon compound (12).

18. Apparatus for carrying out the method according to at least one of Claims 1 to 17, characterised by
a) a reactor (1) which is predominantly made of stainless steel and has at least one glass flange (4) which is disposed in the centre in the reactor wall and which is outwardly sealed with a metal lid (5),
B) heatable electrodes (6, 8, 10, 11) which are disposed in the reactor (1), are situated opposite one another and are connected to an RF generator, one (6) of said electrodes being earthed and designed as a substrate holding plate, whereas the other electrode (8) has at least one opening in the centre of the reactor (1) in the vicinity of the quartz-glass flange (4),
c) a gas inlet (3) contained in the metal lid (5),
d) further gas inlets and outlets (2, 12) in the reactor wall (1) in the peripheral region of the electrode (8) provided with the opening,
e) an RF induction coil (14) which surrounds the quartz-glass flange (4),
f) two magnet coils (18, 19) which are polarised in the same direction disposed outside the quartz-glass flange (4), and
g) means of setting the flowrates and the pressure of the reaction gases in the reactor (1),
the induction coil (14) and the magnet coils (18, 19) being disposed in such a way that, when the apparatus is operated, the RF field (15) and constant magnetic field (16) are mutually perpendicular.

19. Apparatus according to Claim 18, characterised in that a plurality of quartz-glass flanges (4, 24, 44) and gas inlets (3, 23, 43) are provided along the side wall of the reactor (1), one glass cylinder (4, 24, 44) being situated opposite an electrode opening in each case, and in that each flange (4, 24, 44) is surrounded by an induction coil (14, 34, 54) and two magnet coils (18, 19, 28, 29).

20. Apparatus according to Claim 18 or 29, characterised in that the plasma chamber has a rectangular cross-section and the substrates (9) can be moved perpendicular to the long side of the rectangle.

## Revendications

1. Procédé de fabrication de couches minces par dépôt en phase vapeur, qui consiste à exciter des gaz de processus (2, 3, 12) contenant, sous forme gazeuse, le matériau à déposer dans un plasma à décharge gazeuse, le plasma (17) étant produit dans une chambre de réacteur par une excitation (14) haute fréquence par induction, à laquelle est superposé un champ magnétique (16) constant, perpendiculaire au champ HF (15), de manière à créer une résonance d'ondes de cyclotron électronique, à ioniser de manière intense du gaz de processus, le plasma à résonance d'ondes étant superposé à un plasma HF (7) excité capacitivement entre deux électrodes (6, 8).

2. Procédé suivant la revendication 1, caractérisé en ce qu'il consiste à utiliser, pour l'excitation (17) par induction, une fréquence comprise entre 10 et 40 MHz.

3. Procédé suivant la revendication 2, caractérisé en ce qu'il consiste à utiliser une fréquence de 27 MHz.

4. Procédé suivant l'une des revendications 1 à 3, caractérisé en ce qu'il consiste à utiliser pour le champ magnétique (16) constant une intensité du champ comprise entre 10 et 30 Gauss, pour obtenir un maximum de résonance de la résonance d'onde de cyclotron électronique.

5. Procédé suivant l'une des revendications 1 à 4, caractérisé en ce qu'il consiste à disposer un plateau (6) porte-substrat à une distance de 0 à 20 cm du plasma.

6. Procédé suivant l'une des revendications 1 à 5, caractérisé en ce qu'il consiste à utiliser une pression du gaz de processus comprise entre 10⁻³ et 10⁻¹ mbar.

7. Procédé suivant la revendication 6, caractérisé en ce qu'il consiste à utiliser une pression du gaz de processus de 3 x 10⁻² mbar.

8. Procédé suivant l'une des revendications 1 à 7, caractérisé en ce que le gaz de processus contient du silane (SiH₄) et de l'hydrogène (H₂).

9. Procédé suivant l'une des revendications 1 à 7, caractérisé en ce que le gaz de processus contient du germane (GeH₄) et de l'hydrogène (H₂).

10. Procédé suivant l'une des revendications 1 à 9, caractérisé en ce que le gaz du processus est constitué de composés de silicium et de germanium contenant de l'hydrogène et/ou du fluor.

11. Procédé suivant l'une des revendications 1 à 10, caractérisé en ce qu'il consiste à diluer le gaz de processus par de l'hydrogène dans le rapport 1:5 à 1:50.

12. Procédé suivant l'une des revendications 1 à 11, caractérisé en ce qu'il consiste à introduire l'hydrogène (3) par un plateau (5) de fermeture du côté du plasma éloigné du substrat (9).

13. Procédé suivant l'une des revendications 1 à 12, caractérisé en ce qu'il consiste à introduire les gaz de processus réactifs dans la chambre du substrat.

14. Procédé suivant l'une des revendications 1 à 13, caractérisé en ce qu'il consiste à superposer une tension continue comprise entre 0 et ± 200 volt pour accélérer ou pour freiner les ions au plasma de résonance d'onde de cyclotron électronique, cette tension étant appliquée entre le plateau (6) servant de support aux substrats et le plateau (6) de fermeture qui est opposé aux substrats (9) de l'autre côté du plasma.

15. Procédé suivant la revendication 14, caractérisé en ce que la tension continue est de 60 volt.

16. Procédé suivant l'une des revendications 1 à 15, caractérisé en ce qu'il consiste à utiliser, à l'extérieur du plasma de résonance d'onde de cyclotron électroniques, dans la chambre du substrat, un plasma à diode haute fréquence excité capacitivement de 13,5 MHz.

17. Procédé suivant l'une des revendications 1 à 16, caractérisé en ce qu'il consiste à effectuer l'introduction des gaz de réaction (2, 12, 3) dans le réacteur (1), de façon à introduire l'hydrogène (3) centralement pour l'excitation (17) du plasma par induction, tandis que pour le composé de germanium (2) contenant de l'hydrogène et/ou du fluor, ainsi que pour le composé de silicium (12) contenant de l'hydrogène et/ou du fluor, on utilise des entrées dans le réacteur se trouvant dans les parties marginales du plateau (6) porte-substrat.

18. Appareil pour la mise en oeuvre du procédé suivant l'une au moins des revendications 1 à 17, caractérisé par
a) un réacteur (1) principalement en acier fin ayant au moins une bride (4) en verre, qui est disposée au centre dans la paroi du réacteur et qui est rendue étanche vis-à-vis de l'extérieur par un couvercle (5) métallique,
b) des électrodes (6, 8, 10, 11) qui peuvent être chauffées, qui sont disposées en regard dans le réacteur (1), qui sont reliées à un générateur HF dont l'une (6) est mise à la terre et est constituée en plateau porte-substrat, tandis que l'autre (8) comporte, au centre du réacteur (1) dans la partie de la bride (4) en verre au quartz, au moins une traversée,
c) un conduit (3) d'admission de gaz ménagé dans le couvercle (5) métallique,
d) d'autres conduits (2, 12) d'admission et d'évacuation du gaz ménagés dans la paroi (1) du réacteur dans la partie marginale de l'électrode (8) munie de la traversée,
e) une bobine d'induction (14) HF qui entoure la bride (4) en verre au quartz,
f) deux bobines d'électroaimants (18, 19) disposées à l'extérieur de la bride (4) en verre au quartz et polarisées dans le même sens, ainsi que
g) des moyens destinés à régler les vitesses d'écoulement et la pression des gaz de réaction dans le réacteur (1),
les bobines d'induction (14) et les bobines d'électroaimants (18, 19) étant disposées de manière que, lors du fonctionnement de l'appareil, le champ HF (15) et le champ magnétique (16) constant soient perpendiculaires l'un à l'autre.

19. Appareil suivant la revendication 18, caractérisé en ce qu'il est prévu, le long de la paroi latérale du réacteur (1), plusieurs brides (4, 24, 44) en verre au quartz et des conduits (3, 23, 43) d'admission de gaz, un cylindre (4, 24) en verre étant opposé respectivement à une traversée d'électrode et chaque bride (4, 24, 44) étant entourée d'une bobine d'induction (14, 34, 54) et de deux bobines d'électroaimants (18, 19, 28, 29).

20. Appareil suivant la revendication 18 ou 19, caractérisé en ce que la chambre du plasma a une section transversale rectangulaire et les substrats (9) sont mobiles perpendiculairement au grand côté du rectangle.
